(19) Europäisches Patentamt
European Patent Office
Office européen des brevets

(11) **EP 2 162 988 B1**

(12) **EUROPÄISCHE PATENTSCHRIFT**

(45) Veröffentlichungstag und Bekanntmachung des Hinweises auf die Patenterteilung:
**23.05.2012 Patentblatt 2012/21**

(21) Anmeldenummer: **08773363.0**

(22) Anmeldetag: **04.06.2008**

(51) Int Cl.:
*H03M 1/06* (2006.01)     *G04F 10/10* (2006.01)
*H03L 7/081* (2006.01)     *H03L 7/099* (2006.01)
*H03L 7/18* (2006.01)     *H03M 1/12* (2006.01)
*H03M 1/50* (2006.01)

(86) Internationale Anmeldenummer:
**PCT/EP2008/004442**

(87) Internationale Veröffentlichungsnummer:
**WO 2008/148535 (11.12.2008 Gazette 2008/50)**

(54) **ZEIT-AMPLITUDEN-KONVERTER-BAUELEMENT**

TIME-TO-AMPLITUDE CONVERTER COMPONENT

COMPOSANT CONVERTISSEUR TEMPS-AMPLITUDE

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **08.06.2007 DE 102007026684**

(43) Veröffentlichungstag der Anmeldung:
**17.03.2010 Patentblatt 2010/11**

(73) Patentinhaber: **GSI Helmholtzzentrum für Schwerionenforschung GmbH**
**64291 Darmstadt (DE)**

(72) Erfinder:
• **FLEMMING, Holger**
**64291 Darmstadt (DE)**
• **DEPPE, Harald**
**64390 Erzhausen (DE)**

(74) Vertreter: **Rück, Dorothee Maria**
**GSI**
**Helmholtzzentrum für Schwerionenforschung GmbH**
**Planckstraße 1**
**D-64291 Darmstadt (DE)**

(56) Entgegenhaltungen:
• **BADURA E ET AL: "A New TAC-Based Multichannel Front-End Electronics for TOF Experiments With Very High Time Resolution" IEEE TRANSACTIONS ON NUCLEAR SCIENCE, IEEE SERVICE CENTER, NEW YORK, NY, US, Bd. 52, Nr. 3, 1. Juni 2005 (2005-06-01), Seiten 745-747, XP011136852 ISSN: 0018-9499**
• **PIOTR DUDEK ET AL: "A High-Resolution CMOS Time-to-Digital Converter Utilizing a Vernier Delay Line" IEEE JOURNAL OF SOLID-STATE CIRCUITS, IEEE SERVICE CENTER, PISCATAWAY, NJ, US, Bd. 35, Nr. 2, 1. Februar 2000 (2000-02-01), XP011061177 ISSN: 0018-9200**
• **RAISANEN-RUOTSALAINEN E ET AL: "A 5 mW time-to-digital converter based on a stabilized CMOS delay line" CIRCUITS AND SYSTEMS, 1995., PROCEEDINGS., PROCEEDINGS OF THE 38TH MID WEST SYMPOSIUM ON RIO DE JANEIRO, BRAZIL 13-16 AUG. 1995, NEW YORK, NY, USA,IEEE, US, Bd. 1, 13. August 1995 (1995-08-13), Seiten 393-396, XP010165150 ISBN: 978-0-7803-2972-0**
• **JÓZEF KALISZ ET AL: "Review of methods for time interval measurements with picosecond resolution; Methods for time interval measurements" METROLOGIA, INSTITUTE OF PHYSICS PUBLISHING, BRISTOL, GB, Bd. 41, Nr. 1, 1. Februar 2004 (2004-02-01), Seiten 17-32, XP020019859 ISSN: 0026-1394**

EP 2 162 988 B1

- EKENBERG T ET AL: "An analog memory, time-to-amplitude converter and trigger logic chip for PMT applications" NUCLEAR SCIENCE SYMPOSIUM AND MEDICAL IMAGING CONFERENCE, 1994., 1994 IEEE CONFERENCE RECORD NORFOLK, VA, USA 30 OCT.-5 NOV. 1994, NEW YORK, NY, USA,IEEE, US, Bd. 1, 30. Oktober 1994 (1994-10-30), Seiten 30-34, XP010150192 ISBN: 978-0-7803-2544-9

**Beschreibung**

Gebiet der Erfindung

Die Erfindung betrifft ein Zeit-Amplituden-Konverter-Bauelement im Allgemeinen und ein solches bei welchem über ein Widerstandsnetzwerk entlang einer Verzögerungskette ein Kondensator geladen wird im Besonderen.

Hintergrund der Erfindung

Im Bereich der Teilchenphysik ist es an verschiedenen Stellen notwendig, Zeitdifferenzen mit extrem hoher Auflösung zu messen, um z.B. Geschwindigkeiten von Elementarteilchen mit hoher Genauigkeit zu bestimmen. Z.B. wird in Flugzeitmessungen - sogenannte time-of-flight (TOF) Experimente - die Zeitdauer zwischen der Entstehung eines Teilchens und seinem Auftreffen auf einem schnellen zeitauflösenden Detektor bestimmt. Hierbei wird ein sogenanntes Start-Signal, z.B. durch einen weiteren zeitauflösenden Detektor erzeugt. Der erstgenannte Detektor erzeugt ebenfalls ein Signal, welches als Stopp-Signal verwendet wird. Ein Zeitmesser misst die Zeitdifferenz zwischen den beiden Signalen, und aus der Zeitdifferenz kann zum Teil unter Zuhilfenahme weiterer Messdaten z.B. die Geschwindigkeit des Teilchens gemessen werden. Eine solche Messung wird in der Fachwelt als Koinzidenzmessung bezeichnet. Häufig wird der Zeitmesser auch mit einem Detektorsignal gestartet und mit einem Maschinentakt, z.B. bei einem im Pulsbetrieb arbeitetenden Teilchenbeschleuniger gestoppt. Dass hierbei die inverse Flugzeit gemessen wird, ist nicht weiter störend.

Typischerweise werden die Detektorsignale einer Mehrzahl von Verarbeitungsschritten unterzogen, um ein präzises Signaltiming zu erhalten. Ein Beispiel für solch einen Verarbeitungsschritt ist die Verwendung von Verstärkern und Diskriminatoren. Letztere geben ein Normsignal aus, welches in genauer zeitlicher Beziehung zu dem entsprechenden Detektorsignal steht. Derartige Messverfahren, Koinzidenzmessungen und Signalverarbeitung sind dem Fachmann hinlänglich bekannt.

Als Zeitmesser werden typischerweise Zeit-Amplituden-Konverter (engl. time-to-amplitude-converter, kurz TAC) oder Zeit-Digital-Konverter (engl. time-to-digitalconverter, kurz TDC) verwendet. Beide messen die Zeitdifferenz zwischen dem Start-Signal und dem Stopp-Signal, welche in das jeweilige Gerät eingespeist werden.

Ein TAC besitzt also typischerweise einen Start-Eingang und einen Stopp-Eingang auf welche jeweils ein Normsignal gegeben wird. Bei einem TAC wird dann die zeitdifferenz zwischen dem Eintreffen des Start-Signal und des Stopp-Signals in ein analoges Spannungssignal gewandelt, dessen Signalhöhe typischerweise proportional zu der zeitdifferenz ist. Dieses Analogsignal kann dann entweder analog weiterbearbeitet oder z.B. mittels eines nachgeschalteten Analog-Digital-Wandlers (ADC) digitalisiert werden. Bei einem TDC hingegen wird die zeitdifferenz direkt digitalisiert, z.B. um unmittelbar von einem Computer ausgelesen und weiterverarbeitet zu werden, d.h. bei einem TDC wird nicht über ein analoges Signal gearbeitet.

Ein Beispiel für die Anwendung von Zeit-Amplituden-Konvertern ist die Teilchenidentifikation am geplanten CBM-(Compressed Baryonic Matter) Detektor im Rahmen des FAIR-(Facility for Antiproton and Ion Research) Projektes bei der Anmelderin. Je nach Experiment können über die Flugzeit Informationen über die Teilchen, z.B. deren Masse, Masse/Ladungs-Verhältnis, Geschwindigkeit etc. bestimmt werden. Bei diesen Experimenten ist zumeist eine extrem hochauflösende zeitmessung mit einer Genauigkeit im Bereich weit unterhalb einer Nano-Sekunde erforderlich.

Ein schon früher bei der Anmelderin entwickelter Zeit-Amplituden-Konverter ist in der Patentschrift DE 195 33 414 C1 beschrieben. Fig. 1 zeigt ein Blockschaltbild eines derartigen Konverters, der auf einer Verzögerungskette aus CMOS-Inverterpaaren beruht, die über ein Widerstandsnetzwerk einen Kondensator laden. Beim Eintreffen eines Start-Signals wird ein Signal durch die Verzögerungskette geschickt. Über eine parallele Anordnung von Tri-State-Treibern und das Widerstandsnetzwerk wird der Kondensator so geladen, dass die Kondensatorspannung linear mit der Zeit ansteigt. Die verwendeten Tri-State-Treiber sind grundsätzlich z.B. aus N. H. E. Weste, K. Eshraghian: Principles of CMOS VLSI Design, Addison-Wesley, 1994 (Seite 91) oder R. J. Baker, H.W. Li, D. E. Boyce: CMOS Circuit Design, Layout, and Simulation (Seite 226) bekannt. Sobald das Halt-Signal (*Stopp*) eintrifft, trennen die Tri-State-Treiber das Widerstandsnetzwerk von der Verzögerungskette und das Rampensignal bleibt auf einem festen Spannungswert U, der proportional zum Zeitintervall zwischen dem Eintreffen von Start-Signal und Stopp-Signal ist. Nachdem der Analogwert U ausgelesen wurde, kann der Wandler mit einem Reset-Signal an einem Reset-Eingang zurück gesetzt werden.

Bezüglich weiterer Details eines solchen Zeit-Amplituden-Konverters wird auf die DE 195 33 414 C1 verwiesen.

Aus H. Correia et. al: Delay, A 4 channel 1/2 ns programmable delay line chip manual, Version 1.1 CERN, Mai 2005 ist bekannt, eine Verzögerungskette als solche an einem DLL anzukoppeln. Dieser Chip dient jedoch lediglich einer definierten Signalverzögerung.

Ein weiteres Beispiel für einen Time-to-Amplitude Converter findet sich in "A New TAC-Based Multichannel Front-End Electronics for TOF Experiments With Very High Time Resolution", K. Koch et al, veröffentlicht in der "IEEE Transactions on Nuclear Science, Vol.52, No.3, June 2005", welcher bei der Anmelderin entwickelt wurde.

Eine Ausführungsform eines Time-to-Digital Converters findet sich in "A High-Resolution CMOS Time-to-Digital Converter Utilizing a Vernier Delay Linse", P.Dudek et al, veröffentlicht in "IEEE Transactions on Solid-State Circuits, Vol.35, No.2, February 2000".

Allgemeine Beschreibung der Erfindung

TAC-Bauelemente haben sich grundsätzlich bewährt. Es hat sich aber herausgestellt, dass für die extremen Anforderungen, welche die Erfinder an die Genauigkeit und Reproduzierbarkeit stellen, noch weiterer Verbesserungsbedarf besteht. Insbesondere hat sich nämlich herausgestellt, dass die Verzögerungszeit der Verzögerungselemente temperaturabhängigen Schwankungen unterliegt. Ferner hat sich herausgestellt, dass die Bauelemente auch prozessoder chargenabhängigen Toleranzen unterliegen. D.h. so lange zwei TAC-Bauelemente auf demselben Wafer hergestellt werden, sind die Schwankungen relativ gering. Vergleicht man jedoch zwei TAC-Bausteine von unterschiedlichen Wafern, haben diese in nachteiliger Weise unterschiedliche Verzögerungszeiten, was zu einer Verschlechterung der Zeit-Auflösung des Konverters führt, wenn nicht adäquate Gegenmaßnahmen getroffen werden.

Daher wurden bisher Kalibrationsdaten aufgenommen, um diese Abhängigkeiten berücksichtigen zu können, d.h. die Wandler wurden insbesondere bisher zumindest stets auf die jeweilige Umgebungstemperatur kalibriert. Dies funktioniert zwar, ist aber umständlich und setzt eine konstante Temperatur über den Zeitraum der Messung voraus.

Die Erfindung hat sich daher die Aufgabe gestellt, ein zeit-Amplituden-Konverter-Bauelement bereit zu stellen, welches eine hohe Messgenauigkeit und Reproduzierbarkeit besitzt.

Eine spezifischere Aufgabe der Erfindung ist es, ein zeit-Amplituden-Konverter-Bauelement bereit zu stellen, das einfach zu handhaben ist, und ggfs. ohne Kalibrierung bei dennoch hoher Präzision verwendet werden kann.

Die Aufgabe der Erfindung wird durch den Gegenstand des Anspruchs 1 gelöst. Vorteilhafte Weiterbildungen der Erfindung sind in den Unteransprüchen definiert.

Erfindungsgemäß wird ein Zeit-Amplituden-Konverter-Bauelement in integrierter Bauweise zur Messung einer Zeitdifferenz zwischen einem Start-Signal und einem Stopp-Signal, bereit gestellt. Das Bauelement umfasst zumindest eine erste Zeit-Amplituden-Konverter-Schaltung wie in der Einleitung beschrieben. Demnach umfasst die Zeit-Amplituden-Konverter-Schaltung eine Verzögerungskette aus einer Vielzahl von $m$ Stück gleichartigen Verzögerungselementen jeweils mit einer Verzögerungszeit $T_{del}$, so dass die Gesamtverzögerung der Verzögerungskette $m^* T_{del}$ entspricht. Die Verzögerungskette ist an eine Steuereinrichtung angeschlossen in welche die StartSignale, die Stopp-Signale und Reset-Signale eingespeist werden und welche beim Eintreffen des Start-Signals ein Laufsignal auf die Verzögerungskette schickt.

Die Zeit-Amplituden-Konverter-Schaltung umfasst ferner eine Vielzahl von $m$ gleichartigen Tri-State-Treibern (Drei-Zustands-Logikbausteinen), wobei jeweils ein Tri-State-Treiber mit einem Ausgang eines Verzögerungselementes in der Verzögerungskette verbunden ist. Ferner sind die Tri-State-Treiber gemeinsam mit der Steuereinrichtung verbunden, um ein Signal in Ansprechen auf das Eintreffen des Stopp-Signals von der Steuereinrichtung zu erhalten.

Die Zeit-Amplituden-Konverter-Schaltung umfasst ferner ein Widerstandsnetzwerk aus einer Vielzahl von m parallel geschalteten gleichartigen Widerständen, wobei jeweils ein Widerstand mit jeweils einem der Tri-State-Treiber verbunden ist. Ferner umfasst der Zeit-Amplituden-Konverter einen Kondensator, welcher mit den parallel geschalteten Ausgängen der Widerstände verbunden und somit über das Widerstandsnetzwerk ladbar ist. Dadurch wird erreicht, dass nach Eintreffen des Start-Signals und Loslaufen des Laufsignals auf der Verzögerungskette der Kondensator über die Tri-State-Treiber und das Widerstandnetzwerk kontinuierlich geladen wird, so dass sich die Kondensatorspannung linear mit der Laufzeit verändert, solange noch kein Stopp-Signal eingetroffen ist. Mit anderen Worten sind die Ausgänge der einzelnen Verzögerungselemente über die Tri-State-Treiber mit dem verteilten Widerstands-Kapazitätsnetzwerk (RC-Netzwerk) verbunden, wodurch am Ausgang des RC-Netzwerks eine Spannung erzeugt wird, die nach dem Start-Signal proportional zur Zeit ansteigt. Wenn das Stopp-Signal eintrifft, wird, gesteuert von der Steuereinrichtung das Widerstandsnetzwerk mittels der Treiber von der Verzögerungskette getrennt, so dass der Ladevorgang des Kondensators beendet wird. Damit ist am Ausgang des Kondensators ein - nach dem Stopp-Signal konstantes - analoges Spannungssignal abrufbar, welches eine Funktion der Zeitdifferenz zwischen dem Start-Signal und dem Stopp-Signal ist. Diese Funktion repräsentiert die Kennlinie der Konverterschaltung und ist im Idealfall linear, aber prozess- und temperaturabhängig.

Im Unterschied zu dem eingangs beschriebenen Zeit-Amplituden-Konverter besitzt das erfindungsgemäße Bauelement noch eine Stabilisierungseinrichtung zur Stabilisierung der Kennlinie des Zeit-Amplituden-Konverters, welche eine separate Regelungsschaltung zur Erzeugung einer geregelten Steuerspannung enthält. Der Zeit-Amplituden-Konverter und die Regelungsschaltung sind jeweils integriert und auf demselben Chip angeordnet. D.h. die Regelungsschaltung befindet sich außerhalb der Zeit-Amplituden-Konverter-Schaltungen, aber auf demselben Chip und die Regelungsschaltung und die Zeit-Amplituden-Konverter-Schaltungen sind miteinander verbunden. Durch die Anordnung der Regelungsschaltung (DLL oder PLL) auf demselben Chip wie der zeit-Amplituden-Konverter wird erreicht, dass beide dieselbe Temperatur haben. Somit erzeugt die Regelungsschaltung eine temperaturkompensierte Regelungsspannung, mittels derer die Verzögerungselemente des Zeit-Amplituden-Konverters gesteuert werden.

Dadurch ist vorteilhafter Weise die Verzögerungszeit $T_{del}$ jedes Verzögerungselementes mittels der externen Steuerspannung derart geregelt, dass die Temperaturabhängigkeit und die Prozessabhängigkeit weitgehend eliminiert oder zumindest reduziert werden. Die Erfindung gestattet es also, die Vorteile eines Zeit-Amplituden-Konverters zur hochauflösenden Zeitmessung zu nutzen, ohne den Nachteil der Temperaturabhängigkeit in Kauf nehmen zu müssen.

Besonders zweckmäßig ist die Regelungsschaltung als eine Locked Loop-Schaltung, insbesondere als eine Delay Locked Loop- (DLL) Schaltung oder als eine Phase Locked Loop-(PLL) Schaltung ausgebildet.

Die Locked Loop-Schaltung enthält eine Verzögerungskette mit einer Vielzahl von $k$ Stück Verzögerungselementen und einen Phasendetektor, wobei an dem Phasendetektor die geregelte Steuerspannung für den Zeit-Amplituden-Konverter abgegriffen werden kann und aus der Locked-Loop-Schaltung herausgeführt und zu dem Zeit-Amplituden-Konverter geführt wird. Diese geregelte oder phasendifferenzstabilisierte Steuerspannung wird also als Steuerspannung des Zeit-Amplituden-Konverters verwendet. Mit anderen Worten werden die Verzögerungselemente der Locked Loop-Schaltung und des Zeit-Amplituden-Konverters mit der gleichen und von der Locked Loop-Schaltung stabilisierten Regelspannung angesteuert. Die Verzögerungselemente der Locked Loop-Schaltung sind dabei identisch zu denen des Zeit-Amplituden-Konverters. Als Verzögerungselemente haben sich CMOS-Inverterpaare bewährt. Es werden also jeweils Verzögerungselemente bestehend aus zwei Invertern benutzt und die Verzögerungselemente des Zeit-Amplituden-Konverters werden mittels einer externen Referenz aus der Locked-Loop-Schaltung gesteuert, um die Verzögerungskette gegenüber Prozess- und Temperaturschwankungen zu stabilisieren. Hinter dem Phasendetektor folgen zur Erzeugung der Regelspannung noch eine Ladungspumpe und ein Schleifenfilter. Diese Details sind dem Fachmann aber hinlänglich bekannt.

Insbesondere sind die Regelungsschaltung und der Zeit-Amplituden-Konverter an dasselbe Taktsignal, den Systemtakt angeschlossen. Der Systemtakt sollte je nach erwünschter Auflösung des Konverters eine Taktfrequenz von größer als 10 MHz besitzen.

Im Falle einer Delay Locked Loop-Schaltung besteht die Verzögerungskette der Regelungsschaltung vorzugsweise aus einer geradzahligen Anzahl $n = 2*k$ von Invertern und die Verzögerungszeit der Verzögerungskette der Delay Locked Loop-Schaltung beträgt ein ganzzahliges Vielfaches der Zykluszeit des eingespeisten Taktsignals, besonders bevorzugt ist das ganzzahlige Vielfache gleich eins.

Die Anzahl der Verzögerungselemente des Zeit-Amplituden-Konverters sollte größer oder gleich der Anzahl der Verzögerungselemente der Delay Locked Loop-Schaltung, d.h. $m \geq k$ sein. Es ist aber von Vorteil, die Anzahl der Verzögerungselemente des zeit-Amplituden-Konverters tatsächlich größer als die Anzahl der Verzögerungselemente der Delay Locked Loop-Schaltung zu wählen. Hierdurch werden vorteilhafterweise störende Effekte durch Nichtlinearitäten der zeit-Amplituden-Konverter-Schaltung im Anfangs- und Endbereich der Ausgangsspannungsrampe vermieden.

Alternativ zur DLL-Schaltung kann auch eine PLL-Schaltung verwendet werden, die dann einen Ringoszillator enthält, welcher aus einer ungeradzahligen Anzahl $n = 2k+1$ von Invertern besteht.

Gemäß einer bevorzugten Ausführungsform der Erfindung umfasst das Bauelement zwei oder mehr gleichartig aufgebaute parallele Zeit-Amplituden-Konverter-Schaltungen, welche auf demselbem Chip integriert sind. Dadurch können die Verzögerungsketten der mehreren zeit-Amplituden-Konverter-Schaltungen von derselben Regelungsschaltung mit derselben geregelten Steuerspannung gesteuert werden, so dass für mehrere Zeit-Amplituden-Konverter-Schaltungen lediglich eine Regelungsschaltung vorgesehen ist, was den schaltungstechnischen Aufwand reduziert.

Von besonderem Vorteil ist ferner, zwei oder mehr Zeit-Amplituden-Konverter-Schaltungen an deren jeweiligen analogem Spannungsausgang über einen Schalter und einen Buffer zu verbinden. Somit kann wechselseitig einer der Konverter am Bufferausgang ausgelesen werden, während der oder die anderen Konverter messbereit sind.

Bei dem erfindungsgemäßen Zeit-Amplituden-Konverter Bauelement werden für die Weiterverarbeitung der analogen Ausgangssignale der zwei oder mehr Zeit-Amplituden-Konverter-Schaltungen, insbesondere für einige Ladungstransfer- und Schaltprozesse, sowie für die Ablaufsteuerung, die den zugriff der zwei oder mehr Zeit-Amplituden-Konverter-Schaltungen auf den gemeinsamen Ausgang regelt, mehrere Taktsignale verwendet, die in einer genauen und stabilen Phasenbeziehung zueinander stehen.

Solche Mehrphasentaktsignale lassen sich hervorragend aus der DLL-Schaltung ableiten. Somit dient die DLL in dem erfindungsgemäßen Bauelement einer Doppelfunktion: Der Temperaturkompensation der Zeit-Amplituden-Konverter und der Erzeugung eines Mehrphasentaktes für verschiedene Steuerlogiken auf dem Chip.

Im Folgenden wird die Erfindung anhand von Ausführungsbeispielen und unter Bezugnahme auf die Figuren genauer erläutert, wobei gleiche und ähnliche Elemente teilweise mit gleichen Bezugszeichen versehen sind und die Merkmale von verschiedenen Ausführungsbeispielen miteinander kombiniert werden können.

Kurzbeschreibung der Figuren

Es zeigen:

Fig. 1: ein Blockschaltbild eines nicht stabilisierten Zeit-Amplituden-Konverters,

Fig. 2: ein Blockdiagramm eines erfindungsgemäßen Zeit-Amplituden-Konverter-Bauelements in Form eines ASICs und

Fig. 3: ein Ablaufdiagramm der Zeit-Amplituden-Wandlung,

Fig. 4: einen Schaltplan eines Inverters mit steuerbarer Verzögerung,

Fig. 5a: ein Blockschaltbild einer PLL-Schaltung,

Fig. 5b: ein Blockschaltbild einer DLL-Schaltung,

Fig. 6a/b: experimentelle Ergebnisse zur Zeitauflösung des ASICs aus Fig. 2,

Fig. 7 eine Ausschnittsvergrößerung aus Fig. 2 in Form eines Blockdiagramms des SC-Abschwächers 80,

Fig. 8 ein Ablaufdiagramm des Ladungstransfers und der SC-Abschwächung.

Detaillierte Beschreibung der Erfindung

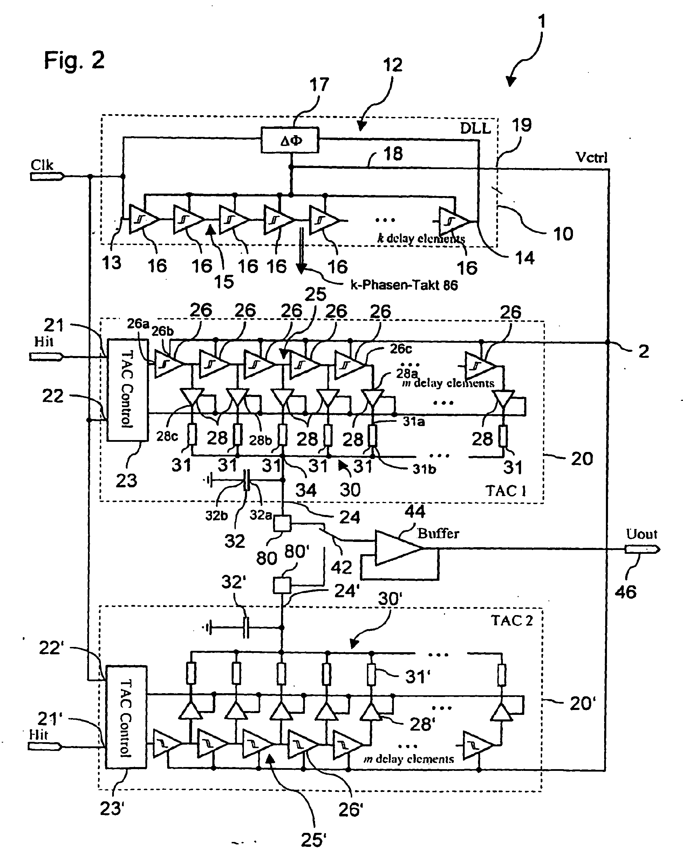

Zur praktischen Erprobung der Erfindung wurde eine anwendungsspezifische integrierte Schaltung (ASIC) 1 entwickelt, die alle notwendigen Baugruppen, einschließlich der Stabilisierungseinrichtung 10 und zweier Zeit-Amplituden-Konverter-Schaltungen 20 und 20' beinhaltet. Fig. 2 zeigt ein Blockdiagramm dieser integrierten Schaltung 1. Als Zeitreferenz wurde eine DLL-Schaltung 12 als Regelungsschaltung der Stabilisierungseinrichtung 10 gewählt. Die DLL-Schaltung wird mit einem externen Systemtakt Clk betrieben. Aus der Phasendifferenz $\Delta\Phi$ zwischen dem Eingangssignal 13 und dem Ausgangssignal 14 der Verzögerungskette 15, bestehend aus $k$ Verzögerungselementen 16 erzeugt der Phasendetektor 17 eine Regelspannung 18 oder $V_{ctrl}$, die aus dem DLL heraus geführt, am Verzweigungspunkt 2 verzweigt und in diesem Beispiel zu zwei Zeit-Amplituden-Konvertern 20 und 20' geführt wird. Darüber hinaus wird nach jedem Verzögerungselement 16 ein Taktsignal abgegriffen, sodass das DLL zusätzlich einen phasenstabilen k-Phasen-Takt 86 liefert, der für Timingzwecke genutzt wird.

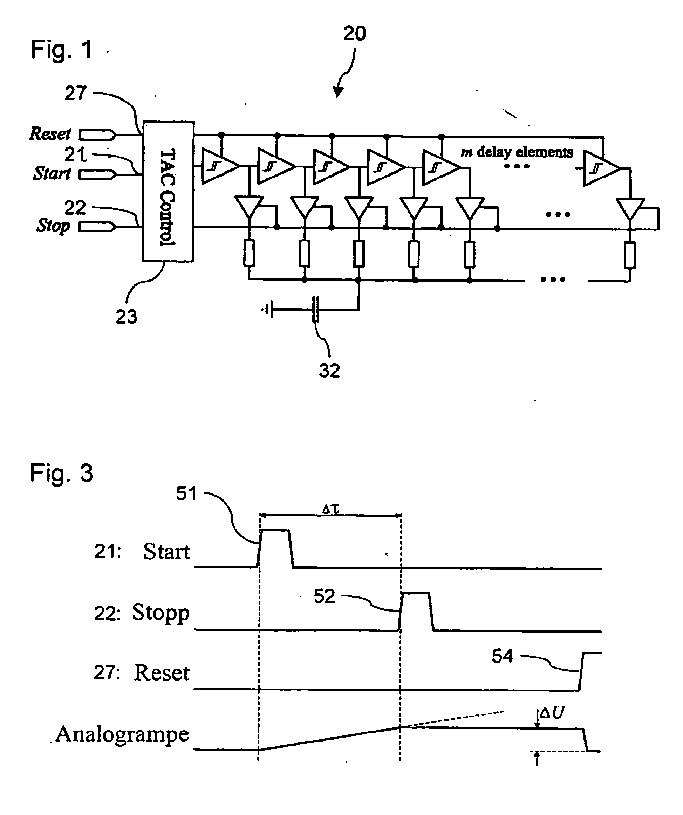

Die integrierte Schaltung 1 enthält ferner die beiden Zeit-Amplituden-Konverter 20 und 20' (TAC1 und TAC2), wie sie in der Beschreibungseinleitung anhand von Fig. 1 beschrieben sind. Wenn im Folgenden der Aufbau des TAC1 20 beschrieben wird, bezieht sich diese Beschreibung auch auf den identisch aufgebauten TAC2 20', dessen Bezugszeichen identisch verwendet werden, aber mit einem Hochkomma versehen sind.

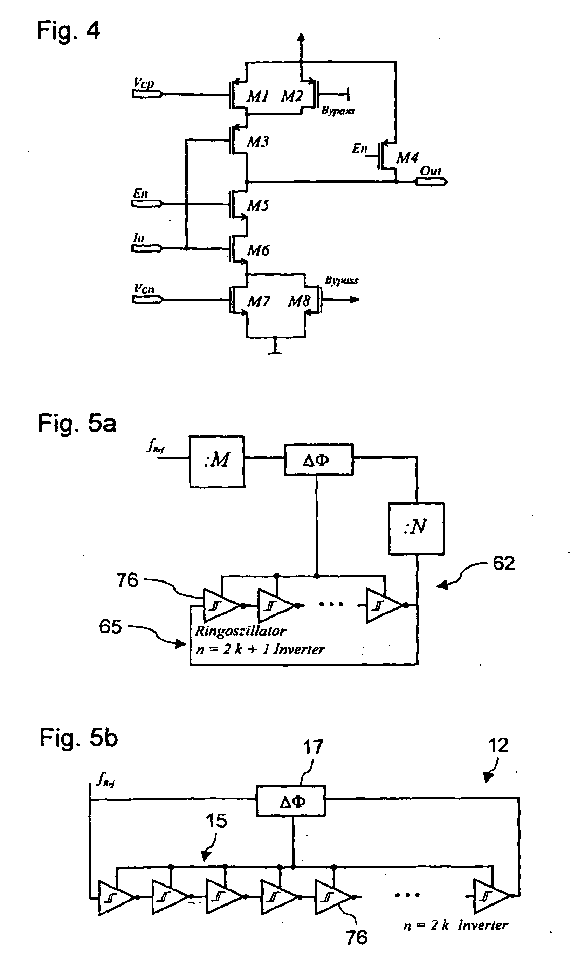

Der TAC1 20 umfasst eine Verzögerungskette 25 aus $m$ Stück identischen Verzögerungselementen 26 in Form von jeweils zwei der nachfolgend anhand von Fig. 4 noch genauer beschriebenen steuerbaren Invertern. Die CMOS-Inverterpaare 26 sind an ihrem Ausgang 26c jeweils mit dem Eingang 26a des nächsten Inverterpaares und einem Eingang 28a eines Tri-State-Treibers 28 verbunden. Somit treibt jedes CMOS-Inverterpaar 26 das nachfolgende. Die Tri-State-Treiber 28 sind an ihrem Eingang 28b zusammengeschaltet und mit der Steuereinrichtung 23 verbunden, um beim Eintreffen eines Stopp-Signals in ihren dritten indifferenten oder hochohmigen Zustand geschaltet zu werden, so dass die Verzögerungskette 25 in Ansprechen auf das Stopp-Signal von dem Widerstandsnetzwerk 30 getrennt wird. Das Widerstandsnetzwerk besteht aus $m$ parallel geschalteten identischen widerständen 31, die jeweils an ihrem Eingang 31a mit dem auf hochohmig schaltbaren Ausgang 28c des zugehörigen Tri-State-Treibers 28 verbunden sind. Die Ausgänge 31b der Widerstände 31 sind zusammengeschaltet, so dass die Ausgänge 28c der Tri-State-Treiber 28 über jeweils einen zugehörigen Widerstand 31 auf den Summations- oder Sternpunkt 34 geführt werden. Der Sternpunkt 34 wiederum ist mit einer Seite 32a eines andererseits 32b geerdeten Kondensators 32 verbunden. Mit anderen Worten sind jeweils ein Verzögerungselement 26, ein Tri-State-Treiber 28 und ein Widerstand 31 parallel auf den Sternpunkt 34 geschaltet, um linear kontinuierlich den Kondensator 32 aufzuladen, solange das Start-induzierte Laufsignal über die Verzögerungskette 25 läuft und die Tri-State-Treiber 28 noch nicht Stopp-induziert hochohmig geschaltet sind.

Wie in Fig. 2 ferner dargestellt ist, sind die Eingänge 26b der CMOS-Inverter-Paare 26 gemeinsam mit dem Regelspannungsausgang 19 der DLL-Schaltung 12 verbunden, so dass jedes Inverterpaar 26 mit derselben geregelten und in Bezug auf den TAC externen Regelspannung Vctrl gesteuert wird. Durch die Ankopplung der Verzögerungselemente 26 an die DLL-Regelspannnung 18 ist sichergestellt, dass die Verzögerungszeit der Verzögerungselemente 26 weitgehend unabhängig von Temperatur- und Prozessvariationen ist.

Beide Zeit-Amplitudenwandler 20, 20' auf dem Chip 1 erhalten getrennte Startsignale (Hit) auf den Start-Eingang 21 bzw. 21' Für diese Testmessung wurden die Stopp-Signale aus dem Systemtakt Clk generiert und jeweils auf den Stopp-Eingang 22 bzw. 22' der als "TAC Control" bezeichneten Steuereinrichtung 23 gegeben. Die Steuereinrichtung oder Steuerlogik 23 speichert in diesem Beispiel die eingehenden Start- und Stopp-Signale oder -impulse. Bei der Verwendung eines zyklischen Taktes als Stopp-Signal, wie bei diesem Testchip 1, wählt der Steuerblock 23 darüber hinaus jeweils die nächste steigende Flanke dieses Systemtaktes für das Anhalten des jeweiligen Konverters 20, 20' aus.

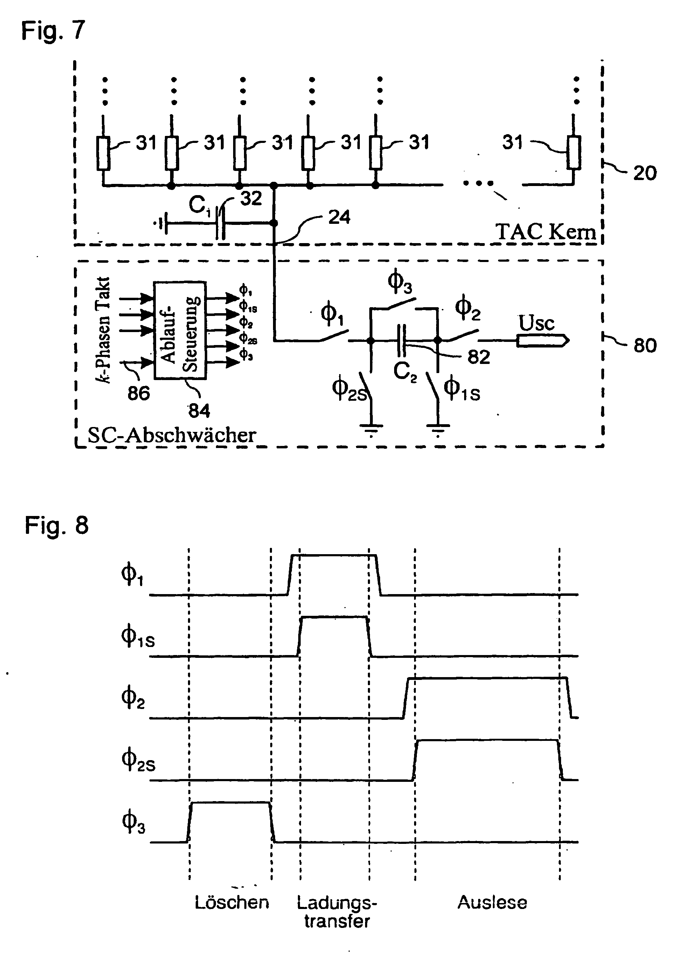

Die von den Konvertern 20, 20' jeweils am TAC-Ausgang 24, 24' erzeugte Ausgangsspannung $U_{out}$ ist ein Maß für die zeitspanne $\Delta\tau$ zwischen dem Start-Signal und dem Stopp-Signal und wird in dem in Fig. 2 dargestellten Ausführungsbeispiel über jeweils einen switched-capacitor-Abschwächer (kurz SC-Abschwächer) 80, 80', der nachfolgend anhand Fig. 7 und 8 näher erläutert wird, sowie über einen Schalter 42 und einen Buffer 44 auf den Ausgang 46 der integrierten Schaltung 1 gegeben. Der Buffer 44 enthält einen Verstärker der unter anderem der Impedanzankopplung zwischen den RC-Ketten in den TACs 20, 20' und der Gerätschaft dient, in die das analoge Spannungssignal $U_{out}$ eingespeist wird, z.B. ein ADC (nicht dargestellt).

Im konkreten Fall des realisierten ASICs 1 wurde eine DLL-Schaltung 12 mit $k = 32$ Verzögerungselementen 16, d.h. mit $n=2*k=64$ Invertern, gewählt. Bei einem Systemtakt von 80MHz erreicht man somit eine Verzögerungszeit von 390,6 ps pro Verzögerungselement 16. In diesem Beispiel wird der Systemtakt Clk auch als Stopp-Signal verwendet. Daher haben die Zeit-Amplituden-Konverter 20, 20' einen Dynamikbereich von mindestens einer Zykluszeit. Somit gilt für die Anzahl der Verzögerungselemente im Wandler: $m \geq k$. Um zu vermeiden, dass Start und Stopp unmittelbar aufeinander folgen, wurde $m = 48 = 1,5 * k > k$ gewählt. Je nach Systemanforderung sind wie dem Fachmann ersichtlich auch andere Parameter möglich.

In Fig. 2 ist der Reset-Eingang der "TAC-Control 23, 23' ausgelassen worden, der in Fig. 1 noch eingezeichnet ist. Das Signal am Reset-Eingang wird von einer komplexen Ablaufsteuerung erzeugt, die den TAC mit einem Reset-Signal zurücksetzt, wenn die Ladung von Kondensator 32 in den SC-Abschwächer 80 transportiert wurde. Eine genaue Synchronisation mit Hilfe des k-Phasen-Taktes 86 verhindert dabei, dass das Rücksetzen erfolgen kann, bevor die Ladung von Kondensator 32 vollständig übernommen wurde. Es wird also das Rücksetzen des jeweiligen Zeit-Amplituden-Konverters 20, 20' mittels des k-Phasen-Taktes 86 synchronisiert.

Diese Ablaufsteuerung, die auch mit dem SC-Abschwächer kommuniziert, ist der besseren Übersicht halber in Fig. 2 weggelassen, da sie nicht in Zusammenhang mit der Temperaturkompensation der TACs steht.

Es ist aber ersichtlich, dass die Zeit-Amplituden-Konverter 20, 20', bzw. die Steuereinrichtungen 23, 23' auch mit separatem Start-Eingang, Stopp-Eingang und Reset-Eingang, wie dies in Fig. 1 dargestellt ist, ausgeführt sein können. Mit dem Reset-Signal werden unter anderem die Tri-State-Treiber 28 wieder aus dem hochohmigen Zustand rückgesetzt.

Fig. 3 zeigt ein Ablaufdiagramm der Zeit-Amplituden-Konversion. Wenn an dem Start-Eingang 21 das Start-Signal 51 eintrifft, beginnt der Konverter 20 den Kondensator 32 zu laden. Wenn nach der Zeit $\Delta\tau$ nach dem Start-Signal 51 das Stopp-Signal 52 an dem Stopp-Eingang 22 eintrifft, wird der Ladevorgang beendet. In diesem Beispiel wird der Kondensator 32 aufgeladen, es ist jedoch ersichtlich, dass der Kondensator bei entsprechend angepasstem Aufbau ausgehend von einer definierten Spannung entladen werden kann, so dass hier unter "laden" "aufladen" oder "entladen" zu verstehen ist. Durch die analoge Interpolation ist die Zeitauflösung bei diesem Verfahren nicht durch die definierte Laufzeit eines Verzögerungselementes 26 begrenzt.

Die Analogrampe ist somit zwischen Start- und Stopp-Signal stetig differenzierbar, insbesondere linear. So können mit derartigen Zeit-Amplituden-Konvertern 20 Zeitauflösungen deutlich besser als 10 ps erreicht werden. Nachdem die analoge Spannung $\Delta U$ hinter dem Buffer 44 als analoges Spannungssignal $U_{out}$ ausgelesen worden ist, wird die Zeit-Amplituden-Konverter-Schaltung 20, 20' durch ein Reset-Signal 54 an einem Reset-Eingang 27 der Steuereinrichtung 23 wieder betriebsbereit geschaltet, indem unter anderem die Tri-State-Treiber 28 rückgesetzt und der Kondensator 32 wieder in seinen Ursprungszustand - hier entladen - versetzt werden.

Bezug nehmend auf Fig. 4 ist ein Inverter eines Verzögerungselements 16, 26, 26' im Detail dargestellt. Zwei hintereinandergeschaltete Inverter gemäß Fig. 4 bilden ein Inverterpaar 16, 26, 26' mit steuerbarer Verzögerungszeit. Die Verzögerungszeit wird über die Regelspannungen $V_{cn}$ und $V_{cp}$ gesteuert. Die Transistoren $M3$ bis $M6$ bilden ein Nicht-Und-Gatter, mit dem ein Freigabemechanismus des Verzögerungselementes realisiert ist. Solange der $En$-Eingang inaktiv (logisch 0) ist, bleibt der Ausgang über den Transistor $M4$ fest mit der Betriebsspannung verbunden. Erst wenn das Enable-Signal $En$ aktiv (logisch 1) wird, sperrt $M4$ und $M5$ wird leitend, so dass die Transistoren $M3$ und $M6$ einen Inverter für das Eingangssignal In bilden und am Ausgang Out nach der definierten Verzögerungszeit das invertierte Eingangssignal anliegt. Der maximale Strom, der durch diesen Inverter fließen kann, wird durch die Transistoren $M1$ und $M7$ begrenzt und kann über die Steuerspannungen, die an den Gates dieser Transistoren anliegen, gesteuert werden. Somit wird mit diesen Spannungen indirekt auch die Verzögerungszeit variiert, die sich aus dem Stromfluss und der Lastkapazität am Ausgang des Elementes und der dadurch gegebenen Zeitkonstante des Umladevorganges bei einem Zustandswechsel ergibt. Über den vorher beschriebenen Zusammenhang ergibt sich die Schwankung der Verzögerungszeit aus der Temperatur- und Prozessabhängigkeit des Stromflusses durch die Transistoren und der Prozessabhängigkeit der Lastkapazitäten.

Die Bypass-Transistoren $M2$ und $M8$ sorgen dafür, dass der Strom durch den Inverter nicht durch die Transistoren $M1$ und $M7$ komplett unterbunden werden kann. Ein minimaler Strom wird stets über $M2$ und $M8$ fließen.

Erfindungsgemäß wird die Verzögerungszeit dieses Elementes im Zeit-Amplituden-Konverter aus einer bekannten Referenzzeit abgeleitet, und zwar über die in Fig. 2 dargestellte Delay Locked Loop- (DLL) Schaltung 12. Alternativ kann auch eine Phase Locked Loop- (PLL) Schaltung verwendet werden.

Bezug nehmend auf Fig. 5a und 5b sind beispielhafte PLL- und DLL-Schaltungen dargestellt. Die DLL-Schaltung in Fig. 5b entspricht derjenigen in Fig. 2.

Bezug nehmend auf Fig. 5a wird bei einer PLL-Schaltung 62 die Phase eines steuerbaren Oszillators 65 mit der Phase eines Referenzfrequenzsignals $f_{Ref}$ verglichen und der Oszillator 65 so nachgeregelt, dass die Phasendifferenz $\Delta\Phi$ verschwindet. Für die hier benötige Stabilisierungseinrichtung 10 wird ein Ringoszillator bestehend aus einer ungeraden Anzahl der beschriebenen Inverter 76 als steuerbarer Oszillator 65 eingesetzt. Bei einer solchen nicht dargestellten Ausführungsform der Erfindung würde die DLL-Schaltung 12 in Fig. 2 durch die PLL-Schaltung 52 ersetzt. Durch den Einsatz von Frequenzteilern können demnach beliebige rationale Verhältnisse zwischen der Referenzfrequenz $f_{Ref}$ und der Oszillatorfrequenz erreicht werden. Die Verzögerungszeit $t_{del}$ eines Inverters 76 beträgt im eingeregelten Zustand:

$$t_{del} = \frac{M}{nNf_{Ref}} \qquad (1)$$

Bezug nehmend auf Fig. 5b ist eine DLL-Schaltung 12, wie sie in Fig. 2 verwendet wird, dargestellt. In einer DLL-Schaltung wird das eingehende Referenzsignal $f_{Ref}$ welches in Fig. 2 durch das Taktsignal Clk realisiert ist, mit der Verzögerungskette 15, bestehend aus einer geraden Anzahl von Invertern 76 verzögert. Am Ausgang der Verzögerungskette 15 ist ein Phasendetektor 17 angeschlossen, der die Phasenlage des Signals am Ausgang der Kette 15 mit dem am Eingang der Kette 15 vergleicht und dabei die Steuerspannung $V_{ctrl}$ der Inverter 76 so nachregelt, dass die Phasendifferenz $\Delta\Phi$ verschwindet. Somit können die PLL- und die DLL-Schaltung beide als verriegelte Schleifenschaltungen, genauer als Phasendifferenzgesteuerte verriegelte Schleifenschaltungen bezeichnet werden. Mit der DLL-Schaltung wird erreicht, dass die Verzögerungszeit der Kette 15 im Allgemeinen genau einem ganzzahligem Vielfachen der Zykluszeit des eingespeisten Taktsignals Clk mit der Frequenz $f_{Ref}$ entspricht. Meist wird die DLL-Schaltung 12 so ausgelegt, dass sich genau eine Zykluszeit als Verzögerungszeit einstellt.

Die Verzögerungszeit $t_{del}$ eines Inverters 76 ist somit durch die Zykluszeit des Taktsignals $T_{zyk}$ und die Anzahl der Inverter $n$ in der Kette 15 gegeben als:

$$t_{del} = \frac{T_{zyk}}{n} = \frac{1}{nf_{Ref}} \qquad (2)$$

In dem vorliegenden Beispiel beträgt die Zykluszeit des Taktsignals $T_{zyk}$ = 12,5 ns = 1/80 MHz. Die Verzögerungszeit eines Verzögerungselements beträgt $T_{del}$ = 2*$t_{del}$ = 390,6 ps und die Anzahl der Verzögerungselemente 16 in der DLL-Schaltung ist $k$ = $n/2$ = 32. Erfindungsgemäß werden in der Stabilisierungseinrichtung oder Referenzeinheit 10 (PLL oder DLL) und im Zeit-Amplituden-Konverter 20, 20' identische Verzögerungselemente 16, 26, 26' verwendet, die mit der gleichen Regelspannung angesteuert werden. Dadurch erhält man im Zeit-Amplituden-Konverter 20, 20' eine Verzögerungsleitung 25, 25', die gegenüber Temperaturschwankungen und Streuungen bei der Herstellung stabilisiert ist.

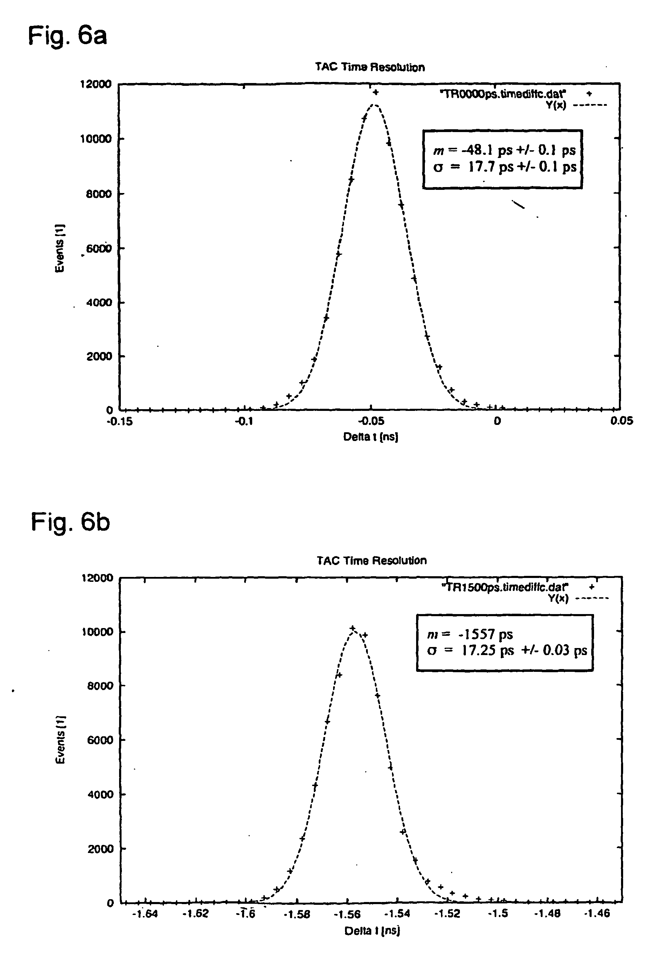

Der in Fig. 2 dargestellte Chip 1 ist inzwischen als ASIC gefertigt worden. Erste Messungen zeigen, dass die Ankopplung der Verzögerungsleitung 25 an eine externe DLL-Schaltung 12 wie erwartet arbeitet. Die Fig. 6a und 6b zeigen die experimentell gemessene Zeitauflösung dieses ASICs. In Fig. 6a ist eine Messung mit synchronen Treffersignalen dargestellt und in Fig. 6b eine Messung mit Hit-Signalen, die gegeneinander um 1,5 ns verzögert sind.

Bei der Messung wurden zwei zeitlich korrelierte Treffersignale auf den stabilisierten TAC-ASIC 1 gegeben, wobei die Möglichkeit besteht, den zeitlichen Abstand dieser Signale zu variieren. Der Systemtakt Clk wurde aus einem getrennten Generator gewonnen, so dass er zu den Treffersignalen unkorreliert ist.

Bei jedem Ereignis wurde mit dem stabilisierten TAC-ASIC 1 der Zeitabstand zwischen den Treffersignalen gemessen und histogrammiert. Das Ergebnis für synchrone Treffersignale ist in Fig. 6a und für Treffersignale mit 1,5 ns Abstand in Fig. 6b dargestellt. Die Zeitauflösung σ zweier korrelierter Kanäle beträgt 17,7 ps (Fig. 6a) bzw. 17,25 ps (Fig. 6b). Die unkorrelierte Zeitauflösung eines einzelnen Kanals lässt sich somit zu 12,2 ps errechnen, was einen ausgezeichneten Wert für hochauflösende Zeitmessung darstellt.

Wieder Bezug nehmend auf Fig. 2 werden neben der Regelspannung $V_{ctrl}$ an den einzelnen Verzögerungselementen 16 der DLL-Schaltung 12 auch entsprechend verzögerte Taktsignale abgegriffen, sodass man bei einer Anzahl von k Verzögerungselementen 16 einen k-Phasen-Takt 86 erhält, der in verschiedenen Ablaufsteuerungen auf dem Chip Verwendung findet. Unter anderem wird die Steuereinrichtung 23, 23' (TAC-Control) mittels des k-Phasen-Takts 86 gesteuert.

Bezug nehmend auf Fig. 7 und 8 wird der k-Phasen-Takt 86 insbesondere zur Ablaufsteuerung der beiden gleich aufgebauten SC-Abschwächer 80, 80' verwendet.

Die Ausgangsspannung des TAC1 20 kann den vollen Bereich der Betriebsspannung überstreichen. Solche sogenannten Rail-to-Rail-Signale lassen sich ausserordentlich schwer mit der geforderten Linearität auf einem ASIC verarbeiten, weshalb zwischen TAC1 20 und Ausgangsbuffer 44 ein Abschwächer 80 eingefügt wurde, der auf der Basis geschalteter Kapazitäten (SC-Abschwächer) arbeitet. Ein Blockdiagramm des dem ersten TAC1 20 zugeordneten und mit dessen analogem Spannungsausgang 24 verbundenen SC-Abschwächers 80 ist in Fig. 7 dargestellt. Der Abschwächer 80 weist einen Kondensator 82 auf, dessen Kapazität $C_2$ in einem vordefinierten Verhältnis zur Kapazität $C_1$ des Ladekondensators 32 im TAC1 (in Fig. 7 als TAC-Kern bezeichnet) 20 steht. Mit den Schaltern $\phi_1$ und $\phi_{1s}$ kann der Kondensator 82 parallel zu dem Kondensator 32 geschaltet werden. Mit den Schaltern $\phi_2$ und $\phi_{2s}$ wird der Kondensator 82 dagegen mit dem Ausgang $U_{sc}$ des SC-Abschwächers 80 verbunden.

Um den Kondensator 82 in einen definierten Ausgangszustand zu bringen, kann er mit dem Schalter $\phi_3$ kurzgeschlossen und damit entladen werden.

Die Ansteuerung der Schalter $\phi_1$ bis $\phi_3$ erfolgt mit einer Ablaufsteuerung 84, die für ein exaktes Timing der Schaltvorgänge mit dem k-Phasen-Takt 86 versorgt wird, der aus der DLL-Schaltung 12 abgeleitet wird, so dass der SC-Abschwächer mittels des k-Phasen-Takt 86 gesteuert wird.

In Fig. 8 ist der zeitliche Ablauf des Vorgangs dargestellt. Um eventuelle Fehler des Messergebnisses durch Restladung auf dem Kondensator 82 zu verhindern, wird der Kondensator 82 vor dem Ladungstransfer durch Aktivieren des Schalters $\phi_3$ entladen. Nachdem der TAC1 20 eine komplette Konversion durchgeführt hat und die Tri-State-Treiber 28 des TAC1 20 hochohmig sind, wird der Kondensator 82 durch Aktivieren der Schalter $\phi_1$ und $\phi_{1s}$ mit dem Ladekondensator 32 des TAC1 20 verbunden. Die Ladung $Q_1 = C_1 \cdot U_{TAC}$, die sich auf dem Ladekondensator 32 befindet, verteilt sich so auf den Kondensator 32 und den Kondensator 82, dass sich die Spannungen über den Kondensatoren 32 und 82, d.h. $U_{TAC}$ und $U_{c2}$ angleichen. Da der Kondensator 82 vor dem Ladungstransfer entladen wurde, beträgt die Summe der Ladungen auf den beiden Kondensatoren 32, 82 nach dem Transfer $Q_1' + Q_2' = Q_1$ . Die Spannung auf beiden Kondensatoren nach dem Ladungstransfer ist somit

$$U'_{C2} = \frac{C_1}{C_1 + C_2} U_{TAC}$$

Durch entsprechende Wahl der Kapazitäten $C_1$ und $C_2$ lässt sich somit das gewünschte Abschwächungsverhältnis einstellen. Im Fall des hier beschriebenen Prototyp-ASICs 1 wurde $C_1 = C_2$ gewählt, sodass eine Abschwächung von 1/2 erreicht wird.

Es werden ferner zwei Schalter $\phi_1$ und $\phi_{1s}$ verwendet, damit der Einfluss parasitärer Kapazitäten z.B. in den Schaltern begrenzt werden kann. Dies ist grundsätzlich aus R. J. BAKER, H.W. LI, D. E. BOYCE: CMOS Circuit Design, Layout, and Simulation, IEEE Press Series on Microelectronic Systems, Wiley Interscience, 1998 und K.R. LAKER, W.M.C. SANSEN: Design of Analog Integrated Circuits and Systems McGraw-Hill, 1994 bekannt.

Durch ein verzögertes Einschalten von $\phi_{1s}$ (vgl. Fig. 8) wird zudem die Ladungsinjektion vermindert. Nachdem der Ladungstransfer beendet ist, wird der Kondensator 82 mittels der Schalter $\phi_2$ und $\phi_{2s}$ mit dem Ausgangsbuffer 44 verbunden, sodass die Spannung $U_{C2}$ am Ausgang 46 des ASICs als Maß für die Meßzeit ausgelesen werden kann.

Innerhalb der Ablaufsteuerung 84 lassen sich die Zeitpunkte der einzelnen Schaltvorgänge durch die Auswahl der richtigen Taktphase aus dem k-Phasen-Takt 86 genau festlegen, sodass ein optimales Timing erreicht werden kann, das auf der einen Seite genügend Zeit für den Ladungstransfer zur Verfügung stellt, aber auf der anderen Seite die Totzeit des TACs möglichst kurz hält. Zudem stellt die Ablaufsteuerung 84 sicher, dass die Schalter $\phi_1$, $\phi_{1s}$ und $\phi_2$, $\phi_{2s}$ nie gleichzeitig geschlossen sind.

Es ist dem Fachmann ersichtlich, dass die vorstehend beschriebenen Ausführungsformen beispielhaft zu verstehen sind, und die Erfindung nicht auf diese beschränkt ist, sondern in vielfältiger Weise variiert werden kann, ohne die Erfindung zu verlassen. Ferner ist ersichtlich, dass die Merkmale unabhängig davon, ob sie in der Beschreibung, den Ansprüchen, den Figuren oder anderweitig offenbart sind auch einzeln wesentliche Bestandteile der Erfindung definieren, selbst wenn sie zusammen mit anderen Merkmalen gemeinsam beschrieben sind.

**Patentansprüche**

1. Zeit-Amplituden-Konverter-Bauelement (1) in integrierter Bauweise zur Messung einer Zeitdifferenz ($\Delta\tau$) zwischen einem Start-Signal (51) und einem Stopp-Signal (52), wobei die Zeitdifferenz in ein analoges Spannungssignal gewandelt wird und die Schaltung folgendes umfasst:

zumindest einen ersten Zeit-Amplituden-Konverter (20) mit

einer Verzögerungskette (25) aus einer Vielzahl (m) von Verzögerungselementen (26) jeweils mit einer Verzögerungszeit ($T_{del}$),

einem Widerstandsnetzwerk (30) mit jeweils einem Widerstand (31) für jedes Verzögerungselement (26),

einem Kondensator (32), welcher mit den Widerständen (31) verbunden und über das Widerstandsnetzwerk (30) ladbar ist,

jeweils einem Treiber (28) für jedes Verzögerungselement (26), wobei jeweils einer der Widerstände (31) über einen der Treiber (28) mit einem der Verzögerungselemente (26) verbunden ist und

einer mit der Verzögerungskette (25) und den Treibern (28) verbundene Steuereinrichtung (23) mit einem Start-Eingang (21) und einem Stopp-Eingang (22),

wobei in Ansprechen auf ein Start-Signal (51) am Start-Eingang (21) ein Laufsignal durch die Verzögerungskette (25) geschickt wird und in Ansprechen auf das Laufsignal über das Widerstandsnetzwerk (30) der Kondensator (32) kontinuierlich geladen wird, so dass sich die Kondensatorspannung mit der Laufzeit verändert,

wobei in Ansprechen auf ein Stopp-Signal (52) am Stopp-Eingang (22) mittels der Treiber (28) das Widerstandsnetzwerk (30) von der Verzögerungskette (25) getrennt wird, so dass der Ladevorgang des Kondensators (32) beendet wird und am Ausgang des Kondensators (32) ein analoges Spannungssignal abrufbar ist, welches eine Funktion der Zeitdifferenz ($\Delta\tau$) zwischen dem Start-Signal (51) und dem Stopp-Signal (52) ist,

**gekennzeichnet durch**

eine Stabilisierungseinrichtung (10) zur Stabilisierung der Kennlinie des Zeit-Amplituden-Konverters (20), welche eine Regelungsschaltung (12) zur Erzeugung einer geregelten Steuerspannung ($V_{ctrl}$) enthält, wobei der Zeit-Amplituden-Konverter (20) und die Regelungsschaltung (12) jeweils integriert und miteinander verbunden sind, wobei der Zeit-Amplituden-Konverter (20) umfassend das Widerstandsnetzwerk (30) und den Kondensator (32) und die Stabilisierungseinrichtung (10) auf demselben Chip angeordnet sind und wobei die Verzögerungselemente (26) des Zeit-Amplituden-Konverters (20) mittels der geregelten Steuerspannung ($V_{ctrl}$) der Regelungsschaltung (12, 62) gesteuert werden.

2. Zeit-Amplituden-Konverter-Bauelement (1) nach Anspruch 1, wobei die Regelungsschaltung als eine Locked Loop-Schaltung (12, 62) ausgebildet ist, welche eine Verzögerungskette (1) mit einer Vielzahl (k) von Verzögerungselementen (16) und einen Phasendetektor (17) enthält und der Phasendetektor (17) die geregelte Steuerspannung ($V_{ctrl}$) für den Zeit-Amplituden-Konverter (20) erzeugt, wobei die Steuerspannung ($V_{ctrl}$) aus der Locked-Loop-Schaltung (12, 62) heraus und zu dem Zeit-Amplituden-Konverter (20) geführt wird, so dass die Verzögerungselemente (16, 26) der Locked Loop-Schaltung (12, 62) und die Verzögerungselemente (26) des Zeit-Amplituden-Konverters (20) mit der gleichen Regelspannung ($V_{ctrl}$) angesteuert werden.

3. Zeit-Amplituden-Konverter-Bauelement (1) nach Anspruch 2, wobei die Verzögerungselemente (26) des Zeit-Amplituden-Konverters (20) und die Verzögerungselemente (16) der Locked Loop-Schaltung (12, 62) identisch ausgebildet sind.

4. Zeit-Amplituden-Konverter-Bauelement (1) nach Anspruch 2 oder 3, wobei die Verzögerungselemente (26) des Zeit-Amplituden-Konverters (20) und der Locked Loop-Schaltung (12) jeweils als CMOS-Inverterpaare (M1-M8) ausgebildet sind.

5. Zeit-Amplituden-Konverter-Bauelement (1) nach einem der Ansprüche 2 bis 4, wobei die Locked Loop-Schaltung (12, 62) eine Delay Locked Loop-Schaltung (12) ist und eine Verzögerungskette (15) aus einer geradzahligen Anzahl ($n=2*k$) von Invertern (76) besteht und wobei jeweils ein Inverterpaar ein Verzögerungselement (16) bildet.

6. Zeit-Amplituden-Konverter-Bauelement (1) nach Anspruch 5, wobei die Verzögerungszeit ($\Delta\tau$) der Verzögerungskette (15) der Delay Locked Loop-Schaltung (12) einem ganzzahligen Vielfachen der Zykluszeit des eingespeisten Taktsignals (Clk) entspricht.

7. Zeit-Amplituden-Konverter-Bauelement (1) nach Anspruch 5 oder 6, wobei die Anzahl der Verzögerungselemente (26) des Zeit-Amplituden-Konverters (20) größer oder gleich der Anzahl der Verzögerungselemente (16) der Delay Locked Loop-Schaltung (12) ist.

8. Zeit-Amplituden-Konverter-Bauelement (1) nach einem der Ansprüche 2 bis 4, wobei die Locked Loop-Schaltung (12, 62) eine Phase Locked Loop-Schaltung (62) ist und einen Ringoszillator (65) aus einer ungeradzahligen Anzahl (2k+1) von Invertern (76) enthält.

9. Zeit-Amplituden-Konverter-Bauelement (1) nach einem der vorstehenden Ansprüche, ferner umfassend einen Abschwächer (80), mittels welchem das analoge Spannungssignal, welches an dem Kondensator (32) des ersten Zeit-Amplituden-Konverters (20) abrufbar ist, abgeschwächt wird.

10. Zeit-Amplituden-Konverter-Bauelement (1) nach Anspruch 9, wobei der Abschwächer (80) eine Ablaufsteuerung (82) umfasst, mittels derer der Abschwächer (80) gesteuert wird und die Ablaufsteuerung (82) mittels eines von der Stabilisierungseinrichtung (10) erzeugten Phasen-Takts (86) gesteuert wird.

11. Zeit-Amplituden-Konverter-Bauelement (1) nach Anspruch 9 oder 10, wobei der Abschwächer (80) als ein Switched-Capacitor-Abschwächer ausgebildet ist.

12. Zeit-Amplituden-Konverter-Bauelement (1) nach Anspruch 11, wobei die Zeitpunkte der Schaltvorgänge in dem Switched-Capacitor-Abschwächer (80) mittels einer ausgewählten Taktphase aus dem von der Stabilisierungseinrichtung (10) erzeugten Phasen-Takt (86) gesteuert werden.

13. Zeit-Amplituden-Konverter-Bauelement (1) nach Anspruch 11 oder 12, wobei der Switched-Capacitor-Abschwächer (80) einen Kondensator (82) und eine Mehrzahl von Schaltern ($\phi_1$ bis $\phi_3$) umfasst, wobei die Schalter von der Ablaufsteuerung (84) gesteuert werden, wobei der Kondensator (82) des Switched-Capacitor-Abschwächers (80) mittels eines Ladeschalters ($\phi_1$) mit dem Kondensator (32) des ersten Zeit-Amplituden-Konverters parallel verbindbar ist und mit einem ausgangsseitigen Erdungsschalter ($\phi_{1s}$) erdbar ist, wobei der ausgangsseitige Erdungsschalter ($\phi_{1s}$), gesteuert durch die Ablaufsteuerung (84), verzögert gegenüber dem Ladeschalter ($\phi_1$) geschlossen wird.

14. Zeit-Amplituden-Konverter-Bauelement (1) nach einem der vorstehenden Ansprüche, wobei zumindest ein zweiter gleichartig aufgebauter Zeit-Amplituden-Konverter (20') umfasst ist, welcher parallel zu dem ersten Zeit-Amplituden-Konverter (20) auf demselbem Chip (1) integriert ist, wobei die Verzögerungsketten (25, 25') des ersten und zweiten Zeit-Amplituden-Konverters (20, 20') mit der gleichen Steuerspannung ($V_{ctrl}$) aus derselben Regelungsschaltung (12, 62) gesteuert werden.

15. Zeit-Amplituden-Konverter-Bauelement (1) nach Anspruch 14, wobei die beiden Kondensatoren (32, 32') der beiden Zeit-Amplituden-Konverter (20, 20') über einen Schalter (42) mit einem Buffer (44) verbunden sind, so dass je nach Schalterstellung am Bufferausgang das analoge, eine Funktion der Zeit repräsentierende Spannungssignal ($V_{ctrl}$) wechselseitig des ersten oder zweiten Zeit-Amplituden-Konverters (20, 20') ausgelesen werden kann, während der jeweils andere Zeit-Amplituden-Konverter messbereit ist.

16. Zeit-Amplituden-Konverter-Bauelement (1) nach Anspruch 15, wobei jedem Zeit-Amplituden-Konverter (20, 20') ein switched-capacitor-Abschwächer (80, 80') zugeordnet ist, um das jeweilige analoge Spannungssignal abzuschwächen, wobei beide switched-capacitor-Abschwächer jeweils eine Ablaufsteuerung (82, 82') umfassen und jeweils von dem von der Stabilisierungseinrichtung (10) erzeugten Phasen-Takt (86) gesteuert werden, und wobei die beiden switched-capacitor-Abschwächer (80, 80') zwischen dem jeweils zugehörigen Zeit-Amplituden-Konverter (20, 20') und dem gemeinsamen Buffer (44) angeordnet sind, so dass am Bufferausgang durch Umschaltung des Schalters (42) wechselseitig das jeweils abgeschwächte analoge Spannungssignal ($U_{sc}$) des ersten oder zweiten Zeit-Amplituden-Konverters (20, 20') ausgelesen werden kann.

**Claims**

1. Time-amplitude converter component (1) constructed as an integrated circuit for measuring a time difference ($\Delta\tau$) between a start signal (51) and a stop signal (52), whereby the time difference is converted into an analogue voltage signal and the circuit comprises the following:

   at least a first time-amplitude converter (20) with
   a delay line (25) consisting of a large number (m) of delay elements (26), each having a delay time ($T_{del}$),
   a resistor network (30) containing one resistor (31) for each delay element (26),
   a capacitor (32) that is connected to the resistors (31) and which can be charged through the resistor network (30),
   a driver (28) for each delay element (26), whereby each resistor (31) is connected through the driver (28) to the delay element (26), and
   a control unit (23) connected to the delay line (25) and to the drivers (28) with a start input (21) and a stop input (22), whereby in response to a start signal (51) at the start input (21) a run signal is sent through the delay line (25), and in response to the run signal the capacitor (32) is continuously charged through the resistor network (30), so that the capacitor voltage changes throughout the run time,

whereby in response to a stop signal (52) at the stop input (22) the resistor network (30) is disconnected from the delay line (25) by means of the driver (28), so that the process of charging the capacitor (32) is ended and an analogue voltage signal is available at the output of the capacitor (32), being a function of the time difference ($\Delta\tau$) between the start signal (51) and the stop signal (52),

**characterised by**

a stabilisation unit (10) for stabilising the characteristic curve of the time-amplitude converter (20), containing a regulator circuit (12) that generates a regulated control voltage ($V_{ctrl}$), whereby the time-amplitude converter (20) and the regulator circuit (12) are integrated and are connected to one another, whereby the time-amplitude converter (20) comprising the resistor network (30) and the capacitor (32) and the stabilisation unit (10) are arranged on the same chip, and whereby the delay elements (26) of the time-amplitude converter (20) are controlled by means of the regulated control voltage ($V_{ctrl}$) of the regulator circuit (12, 62).

2. Time-amplitude converter component (1) according to Claim 1, whereby the regulator circuit is implemented as a locked-loop circuit (12, 62), which contains a delay line (1) with a large number (*k*) of delay elements (16) and a phase detector (17), and the phase detector (17) generates the regulated control voltage ($V_{ctrl}$) for the time-amplitude converter (20), whereby the control voltage ($V_{ctrl}$) is passed from the locked-loop circuit (12, 62) to the time-amplitude converter (20), so that the delay elements (16, 26) of the locked-loop circuit (12, 62) and the delay elements (26) of the time-amplitude converter (20) are controlled using the same control voltage ($V_{ctrl}$).

3. Time-amplitude converter component (1) according to Claim 2, whereby the delay elements (26) of the time-amplitude converter (20) and the delay elements (16) of the locked-loop circuit (12, 62) are of identical design.

4. Time-amplitude converter component (1) according to Claim 2 or 3, whereby the delay elements (26) of the time-amplitude converter (20) and the locked-loop circuit (12) are each implemented as CMOS inverter pairs (M1-M8).

5. Time-amplitude converter component (1) according to one of Claims 2 to 4, whereby the locked-loop circuit (12, 62) is a delay locked-loop circuit (12) and a delay line (15) consists of an even number (n=2*k) of inverters (76), and whereby each pair of inverters constitutes a delay element (16).

6. Time-amplitude converter component (1) according to Claim 5, whereby the delay time ($\Delta\tau$) of the delay line (15) of the delay locked-loop circuit (12) is an integral multiple of the cycle time of the incoming clock signal (Clk).

7. Time-amplitude converter component (1) according to Claim 5 or 6, whereby the number of delay elements (26) of the time-amplitude converter (20) is greater than or equal to the number of delay elements (16) of the delay locked-loop circuit (12).

8. Time-amplitude converter component (1) according to one of Claims 2 to 4, whereby the locked-loop circuit (12, 62) is a phase locked-loop circuit (62) and contains a ring oscillator (65) consisting of an uneven number (2k+1) of inverters (76).

9. Time-amplitude converter component (1) according to one of the foregoing claims, further comprising an attenuator (80) by means of which the analogue voltage signal that can be obtained from the capacitor (32) of the first time-amplitude converter (20) is attenuated.

10. Time-amplitude converter component (1) according to Claim 9, whereby the attenuator (80) incorporates a sequence controller (82), by means of which the attenuator (80) is controlled, and the sequence controller (82) is controlled by a phase clock (86) generated by the stabilisation unit (10).

11. Time-amplitude converter component (1) according to Claim 9 or 10, whereby the attenuator (80) is implemented as a switched-capacitor attenuator.

12. Time-amplitude converter component (1) according to Claim 11, whereby the time of the switching processes in the switched-capacitor attenuator (80) is controlled by a selected clock phase from the phase clock (86) generated by the stabilisation unit (10).

**13.** Time-amplitude converter component (1) according to Claim 11 or 12, whereby the switched-capacitor attenuator (80) contains a capacitor (82) and a large number of switches ($\phi_1$ to $\phi_3$), whereby the switches are controlled by the sequence controller (84), whereby the capacitor (82) of the switched-capacitor attenuator (80) can be connected by means of a charging switch ($\phi_1$) in parallel with the capacitor (32) of the first time-amplitude converter and can be grounded by a grounding switch ($\phi_{1s}$) at the output, whereby the grounding switch ($\phi_{1s}$) at the output, under the control of the sequence controller (84), is closed after a delay with respect to the charging switch ($\phi_1$).

**14.** Time-amplitude converter component (1) according to one of the foregoing claims, whereby at least one second time-amplitude converter (20') designed in the same way is included, which is integrated on the same chip (1) in parallel with the first time-amplitude converter (20), whereby the delay lines (25, 25') of the first and second time-amplitude converters (20, 20') are controlled by the same control voltage ($V_{ctrl}$) from the same regulator circuit (12, 62).

**15.** Time-amplitude converter component (1) according to Claim 14, whereby the two capacitors (32, 32') of the two time-amplitude converters (20, 20') are connected through a switch (42) to a buffer (44), so that, depending on the switch position, the analogue voltage signal ($V_{ctrl}$) that represents a function of the time can be read alternately from the first or second time-amplitude converters (20, 20') at the buffer output, while the other time-amplitude converter is ready for measurement.

**16.** Time-amplitude converter component (1) according to claim 15, whereby each time-amplitude converter (20, 20') is associated with a switched-capacitor attenuator (80, 80'), in order to attenuate the corresponding analogue voltage signal, whereby both switched-capacitor attenuators each comprise a sequence controller (82, 82') and is controlled by the phase clock (86) generated by the stabilisation unit (10), and whereby the two switched-capacitor attenuators (80, 80') are arranged between the time-amplitude converter (20, 20') associated with each and the common buffer (44), so that by changing over the switch (42) the attenuated analogue voltage signal ($U_{sc}$) from the first or second time-amplitude converter (20, 20') can be read alternately at the buffer output.

**Revendications**

**1.** Composant convertisseur temps-amplitude (1) de type intégré destiné à mesurer une différence de temps ($\Delta\tau$) entre un signal de démarrage (51) et un signal d'arrêt (52), dans lequel la différence de temps est convertie en un signal de tension analogique et le circuit comprend ce qui suit :

au moins un premier convertisseur temps-amplitude (20) avec
une chaîne de temporisation (25) constituée d'une pluralité (m) de temporisateurs (26) ayant chacun une durée de temporisation ($T_{del}$),
un réseau de résistances (30) avec respectivement une résistance (31) pour chaque temporisateur (26),
un condensateur (32) qui est relié aux résistances (31) et qui peut être chargé par l'intermédiaire du réseau de résistances (30),
respectivement un excitateur (28) pour chaque temporisateur (26), sachant que respectivement chacune des résistances (31) est reliée à un des temporisateurs (26) par l'intermédiaire d'un des excitateurs (28), et
un dispositif de commande (23) avec une entrée Démarrage (21) et une entrée Arrêt (22) qui est relié à la chaîne de temporisation (25) et aux excitateurs (28),
sachant qu'en réponse à un signal de démarrage (51) à l'entrée Démarrage (21), un signal de propagation est envoyé à travers la chaîne de temporisation (25) et qu'en réponse au signal de propagation, le condensateur (32) est chargé en continu par l'intermédiaire du réseau de résistances (30) de sorte que la tension du condensateur se modifie avec le temps de propagation, et
qu'en réponse à un signal d'arrêt (52) à l'entrée Arrêt (22), le réseau de résistances (30) est coupé de la chaîne de temporisation (25) au moyen des excitateurs (28) de sorte qu'il est mis fin à la charge du condensateur (32) et qu'à la sortie du condensateur (32) peut être prélevé un signal de tension analogique qui est une fonction de la différence de temps ($\Delta\tau$) entre le signal de démarrage (51) et le signal d'arrêt (52),

**caractérisé par**
un dispositif de stabilisation (10) destiné à stabiliser la caractéristique du convertisseur temps-amplitude (20) et qui comprend un circuit régulateur (12) pour générer une tension pilote régulée ($V_{ctrl}$), sachant que le convertisseur temps-amplitude (20) et le circuit régulateur (12) sont respectivement intégrés et reliés entre eux, que le convertisseur temps-amplitude (20) comprenant le réseau de résistances (30) et le condensateur (32) ainsi que le dispositif de stabilisation (10) sont disposés sur la même puce électronique, et que les temporisateurs (26) du convertisseur temps-amplitude (20) sont pilotés par la tension pilote régulée ($V_{ctrl}$) du circuit régulateur (12, 62).

2. Composant convertisseur temps-amplitude (1) selon la revendication 1, sachant que le circuit régulateur est conçu en tant que circuit en boucle à verrouillage (12, 62) qui comprend une chaîne de temporisation (1) avec une pluralité (k) de temporisateurs (16) et un détecteur de phase (17), et que le détecteur de phase (17) génère la tension pilote ($V_{ctrl}$) pour le convertisseur temps-amplitude (20), la tension pilote ($V_{ctrl}$) étant issue du circuit en boucle à verrouillage (12, 62) et amenée au convertisseur temps-amplitude (20) de sorte que les temporisateurs (16, 26) du circuit en boucle à verrouillage (12, 62) et les temporisateurs (26) du convertisseur temps-amplitude (20) sont pilotés par la même tension régulée ($V_{ctrl}$).

3. Composant convertisseur temps-amplitude (1) selon la revendication 2, dans lequel les temporisateurs (26) du convertisseur temps-amplitude (20) et les temporisateurs (16) du circuit en boucle à verrouillage (12, 62) sont de conception identique.

4. Composant convertisseur temps-amplitude (1) selon la revendication 2 ou 3, dans lequel les temporisateurs (26) du convertisseur temps-amplitude (20) et du circuit en boucle à verrouillage (12) sont respectivement conçus en tant que paires d'inverseurs CMOS (M1-M8).

5. Composant convertisseur temps-amplitude (1) selon l'une des revendications 2 à 4, dans lequel le circuit en boucle à verrouillage (12, 62) est un circuit en boucle à verrouillage de retard (12), qu'une chaîne de temporisation (15) est constituée d'un nombre pair ($n=2*k$) d'inverseurs (76) et que chaque paire d'inverseurs forme un temporisateur (16).

6. Composant convertisseur temps-amplitude (1) selon la revendication 5, dans lequel la durée de temporisation ($\Delta\tau$) de la chaîne de temporisation (15) du circuit en boucle à verrouillage de retard (12) correspond à un multiple entier du temps de cycle du signal d'horloge (Clk) fourni.

7. Composant convertisseur temps-amplitude (1) selon la revendication 5 ou 6, dans lequel le nombre de temporisateurs (26) du convertisseur temps-amplitude (20) est supérieur ou égal au nombre de temporisateurs (16) du circuit en boucle à verrouillage de retard (12).

8. Composant convertisseur temps-amplitude (1) selon l'une des revendications 2 à 4, dans lequel le circuit en boucle à verrouillage (12, 62) est un circuit en boucle à verrouillage de phase (62), et comprend un oscillateur annulaire (65) constitué d'un nombre impair (2k+1) d'inverseurs (76).

9. Composant convertisseur temps-amplitude (1) selon l'une des revendications précédentes, comprenant en outre un atténuateur (80) à l'aide duquel est atténué le signal de tension analogique qui peut être prélevé au condensateur (32) du premier convertisseur temps-amplitude (20).

10. Composant convertisseur temps-amplitude (1) selon la revendication 9, dans lequel l'atténuateur (80) comprend une commande séquentielle (82) à l'aide de laquelle est piloté l'atténuateur (80), et la commande séquentielle (82) est pilotée par un signal d'horloge de phase (86) généré par le dispositif de stabilisation (10).

11. Composant convertisseur temps-amplitude (1) selon la revendication 9 ou 10, dans lequel l'atténuateur (80) est conçu en tant qu'atténuateur à capacités commutées.

12. Composant convertisseur temps-amplitude (1) selon la revendication 11, dans lequel les instants de commutation dans l'atténuateur à capacités commutées (80) sont pilotés au moyen d'une phase d'impulsion sélectionnée provenant du signal d'horloge de phase (86) généré par le dispositif de stabilisation (10).

13. Composant convertisseur temps-amplitude (1) selon la revendication 11 ou 12, dans lequel l'atténuateur à capacités commutées (80) comprend un condensateur (82) et une pluralité d'interrupteurs ($\phi_1$ à $\phi_3$), sachant que les interrupteurs sont pilotés par la commande séquentielle (84), que le condensateur (82) de l'atténuateur à capacités commutées (80) peut être branché en parallèle avec le condensateur (32) du premier convertisseur temps-amplitude au moyen d'un interrupteur de charge ($\phi_1$), et mis à la terre par un interrupteur de mise à la terre ($\phi_{1s}$) côté sortie, que l'interrupteur de mise à la terre ($\phi_{1s}$) côté sortie, piloté par la commande séquentielle (84), est fermé avec retard par rapport à l'interrupteur de charge ($\phi_1$).

**14.** Composant convertisseur temps-amplitude (1) selon l'une des revendications précédentes, comprenant au moins un deuxième convertisseur temps-amplitude (20') de structure identique, qui est intégré sur la même puce électronique (1) parallèlement au premier convertisseur temps-amplitude (20), sachant que les chaînes de temporisation (25, 25') du premier et du deuxième convertisseurs temps-amplitude (20, 20') sont pilotées par la même tension pilote ($V_{ctrl}$) du même circuit régulateur (12, 62).

**15.** Composant convertisseur temps-amplitude (1) selon la revendication 14, dans lequel les deux condensateurs (32, 32') des deux convertisseurs temps-amplitude (20, 20') sont reliés à un circuit tampon (44) par un commutateur (42), si bien qu'en alternance selon la position de commutateur le signal de tension analogique ($V_{ctrl}$) du premier ou du deuxième convertisseur temps-amplitude (20, 20') et représentant une fonction du temps, peut être extrait à la sortie du circuit tampon, tandis que l'autre convertisseur temps-amplitude est prêt à mesurer.

**16.** Composant convertisseur temps-amplitude (1) selon la revendication 15, dans lequel un atténuateur à capacités commutées (80, 80') est associé à chaque convertisseur temps-amplitude (20, 20') afin d'atténuer les signaux de tension analogiques respectifs, sachant que les deux atténuateurs à capacités commutées comprennent chacun une commande séquentielle (82, 82') et sont chacun pilotés par le signal d'horloge de phase (86) généré par le dispositif de stabilisation (10), et que les deux atténuateurs à capacités commutées (80, 80') sont disposés entre les convertisseurs temps-amplitude (20, 20') respectivement associés et le circuit tampon commun (44), si bien que par basculement du commutateur (42), le signal de tension analogique atténué ($U_{sc}$) du premier ou du deuxième convertisseur temps-amplitude (20, 20') peut être extrait alternativement à la sortie du circuit tampon.

Fig. 1

20

27

Reset

21

Start

22

Stop

TAC Control

23

m delay elements

• • •

• • •

• • •

32

Fig. 3

51

Δτ

21: Start

52

22: Stopp

54

27: Reset

ΔU

Analogrampe

Fig. 2

## Fig. 4

## Fig. 5a

## Fig. 5b

## Fig. 6a

TAC Time Resolution

m = -48.1 ps +/- 0.1 ps
σ = 17.7 ps +/- 0.1 ps

## Fig. 6b

TAC Time Resolution

m = -1557 ps
σ = 17.25 ps +/- 0.03 ps

## Fig. 7

## Fig. 8

Löschen     Ladungs-     Auslese
transfer

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19533414 C1

**In der Beschreibung aufgeführte Nicht-Patentliteratur**

- **N. H. E. WESTE ; K. ESHRAGHIAN.** Principles of CMOS VLSI Design. Addison-Wesley, 1994, 91
- **R. J. BAKER ; H.W. LI ; D. E. BOYCE.** *CMOS Circuit Design, Layout, and Simulation,* 226
- **K. KOCH et al.** A New TAC-Based Multichannel Front-End Electronics for TOF Experiments With Very High Time Resolution. *IEEE Transactions on Nuclear Science,* Juni 2005, vol. 52 (3
- **P.DUDEK et al.** A High-Resolution CMOS Time-to-Digital Converter Utilizing a Vernier Delay Linse. *IEEE Transactions on Solid-State Circuits,* Februar 2000, vol. 35 (2
- CMOS Circuit Design, Layout, and Simulation. **R. J. BAKER ; H.W. LI ; D. E. BOYCE.** IEEE Press Series on Microelectronic Systems. Wiley Interscience, 1998
- **K.R. LAKER, W.M.C. SANSEN.** Design of Analog Integrated Circuits and Systems. McGraw-Hill, 1994